# EUROPEAN PATENT APPLICATION

(11) **EP 1 453 205 A1**
(43) Date of publication of application: **01.09.2004**
(21) Application number: 04003551.1
(22) Date of filing: 17.02.2004
(51) Int. Cl.: H03L 7/14, H03L 7/10, H03L 7/083

(54) **PLL circuit and method of use**

(30) Priority: 25.02.2003 KR 2003011685
(71) Applicant: LG ELECTRONICS INC., Seoul (KR)
(72) Inventor: Baek, Jong-Hyuk, Gunpo-gu, Gyeonggi-Do (KR)
(74) Representative: von Hellfeld, Axel, Dr. Dipl.-Phys.

(57) **Abstract**

A PLL circuit may include a memory for storing a control voltage and a processor for loading a control voltage, which corresponds to a changed channel, from the memory when a system channel is changed, and providing the control voltage to a Voltage Control Oscillator (VCO). Whenever a system changes a channel, a control voltage of a pertinent channel frequency that has been stored in the memory may be used as an initial value of a control voltage provided to the VCO 50 so that a time (i.e., a lock time) to perform a phase lock looping may be remarkably reduced. This may improve a processing speed of various communication equipments and their performance.

## Description

The present disclosure claims priority from Korean Patent Application No. 11685/2003, filed February 25, 2003, the subject matter of which is incorporated herein by reference.

### BACKGROUND OF THE INVENTION

### 1. Field of the Invention

The present invention may relate to a synchronizing device of a communication system. More particularly, the present invention may relate to a Phase Lock Loop (PLL) circuit.

### 2. Background of the Related Art

A PLL circuit is a composite circuit for generating a signal of a frequency needed for communication or various signal transmissions. The PLL circuit may lock a generated signal at a stable frequency.

A PLL circuit may be used in a digital field and also in an analog electronic circuit system. The PLL circuit may be used as a frequency synthesizer or a frequency-oscillating source of various radio transmitter/receivers, for example.

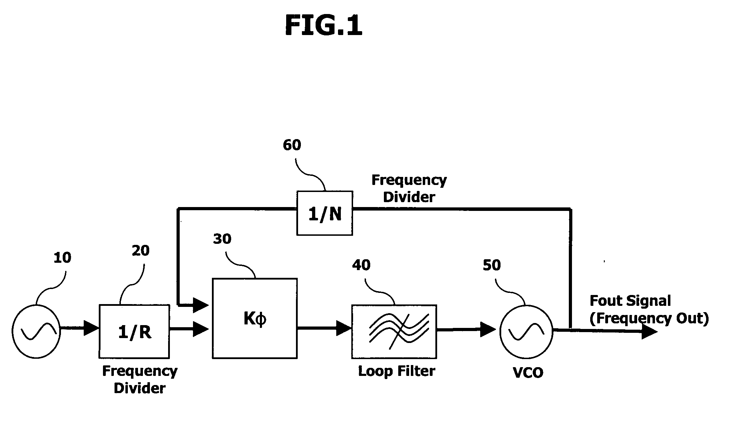

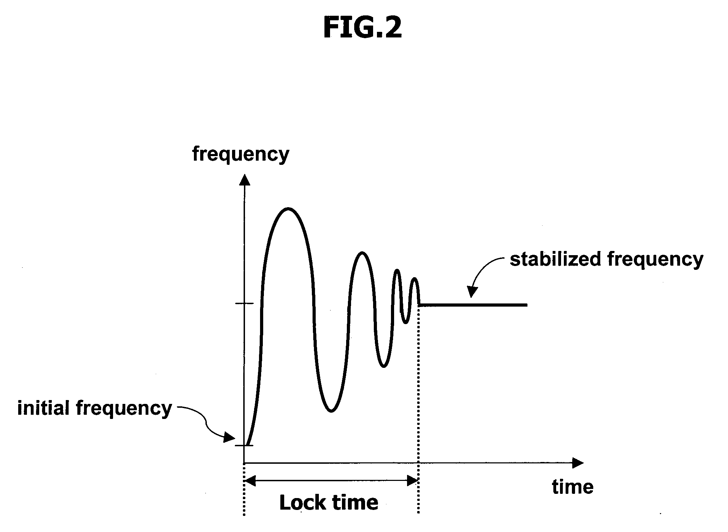

A PLL circuit will now be described with reference to Figures 1 and 2. Figure 1 is a block diagram showing a structure of a PLL circuit according to an example arrangement. Other arrangements are also possible. As shown, the PLL circuit may include a frequency generator 10, a first frequency divider 20, a phase detector 30, a loop filter 40, a voltage controlled oscillator 50, an a second frequency divider 60. The frequency generator 10 may be for generating a signal of a reference frequency. The first frequency divider 20 may generate a signal of a frequency (i.e., a reference frequency) having a predetermined constant ratio (1/R) in relation to the reference frequency. The phase detector 30 may compare a phase of the signal of the reference frequency and a phase of a signal fed back from the second frequency divider 60 and output a signal of a voltage (hereinafter, referred to as 'control voltage or turning voltage") that is proportional to a phase difference of the two signals. The loop filter 40 may eliminate a harmonic component included in the output signal of the phase detector 30. The voltage controlled oscillator (VCO) 50 may receive the output signal of the phase detector 30 through the loop filter 40, and output a signal (i.e., a Fout signal) of a frequency according to a voltage of the inputted signal. The second frequency divider 60 may generate a signal of a frequency having a predetermined constant ratio (1/N) in relation to a frequency of the output signal (i.e., the Fout signal) by referring to the output signal (Fout signal) of the VCO 50. The second frequency divider 60 may apply the generated signal to the phase detector 30.

A phase lock looping of the PLL circuit will now be described. First, the frequency generator 10 generates a signal of a reference frequency and applies the signal to the first frequency divider 20. The first frequency divider 20 generates a signal of a frequency (i.e., a reference frequency) having a predetermined constant ratio (1/R) in relation to the reference frequency, and applies the generated signal to the phase detector 30.

The phase detector 30 compares a phase of the signal of the reference frequency and a phase of a signal inputted from the second frequency divider 60, and outputs a 'control voltage signal' proportional to a phase difference of the two signals. The loop filter 40 may eliminate a harmonic component included in the control voltage signal and then apply the signal to the VCO 50. The loop filter 40 may have a low pass filter structure, and filters sundry frequencies generated during looping.

When the control voltage signal is applied to the VCO 50, the VCO 50 may generate a signal having a frequency according to the voltage of the applied signal. Then, the signal outputted from the VCO 50 becomes an output signal (i.e., the Fout signal) of the PLL circuit.

The second frequency divider 60 may generate a signal of a frequency having a predetermined constant ratio (1/N) in relation to a frequency of the output signal (i.e., the Fout signal) with reference to the output signal (Fout signal). The second frequency divider 60 may apply the generated signal to the phase detector 30.

By repeating the above processes several times, a frequency of the output signal (Fout signal) may become stable. That is, the output signal (Fout signal) of the PLL circuit may be locked at a specific frequency. The time consumed until the output signal (Fout signal) of the PLL circuit is locked up at a specific frequency may be called a lock time as shown in Figure 2, for example.

Accordingly, whenever a system requires an output signal (Fout signal) of a new frequency, the PLL circuit may consume a certain amount of time (i.e., a lock time) to stabilize a frequency (or lock-up a frequency). Such a lock time of the PLL circuit is one of the problems that may cause degradation of performance of a communication system.

### SUMMARY OF THE INVENTION

An object of the invention is to solve at least the above problems and/or disadvantages and to provide at least the advantages described hereinafter. Another object of the present invention may be to provide a PLL circuit for shortening a lock time of a PLL circuit.

Embodiments of the present invention may provide a PLL circuit that includes a memory for storing a control voltage (by system channels) and a processor for loading a control voltage that corresponds to a changed channel from a memory when a system channel is changed. The memory may provide the control voltage to a Voltage Control Oscillator (VCO).

The control voltage may be stored when a system including a PLL circuit is initialized. The control voltage of the memory may be provided to the VCO as an initial value of the control voltage.

Embodiments of the present invention may provide a method for synchronizing a phase of a frequency in a PLL circuit for obtaining a stable frequency by performing a phase lock looping. This may include storing a control voltage (by system channels) in a memory and loading a control voltage that corresponds to a changed channel, from the memory when a system channel is changed. The control voltage may be applied to the VCO. The applied control voltage may be set as an initial control voltage. The method may also include performing a phase lock looping.

Additional advantages, objects, features and embodiments of the invention will be set forth in part in the description that follows and in part may become apparent to those having ordinary skill in the art upon examination of the following or may be learned from practice of the invention.

### BRIEF DESCRIPTION OF THE DRAWINGS

The accompanying drawings, which are included to provide a further understanding of the invention and are incorporated in and constitute a unit of this specification, illustrate embodiments of the invention and together with the description serve to explain the principles of the invention.

Embodiments of the present invention will be described in detail with reference to the following drawings in which like reference numerals refer to like elements and wherein:

Figure 1 is a block diagram showing a structure of a PLL circuit according to an example arrangement;

Figure 2 is a graph showing a process of stabilizing an output signal (Fout signal) according to an example arrangement;

Figure 3 is a block diagram showing a structure of a PLL circuit in accordance with an example embodiment of the present invention;

Figure 4 is a flow chart showing operation processes of a PLL circuit in accordance with an example embodiment of the present invention; and

Figure 5 is a flow chart showing processes of detecting an initial voltage according to an example embodiment of the present invention.

### DETAILED DESCRIPTION OF PREFERRED EMBODIMENTS

Reference will now be made in detail to example embodiments of the present invention that may be illustrated in the accompanying drawings. Well-known functions and structures may not be described in detail so as not to obscure the present invention.

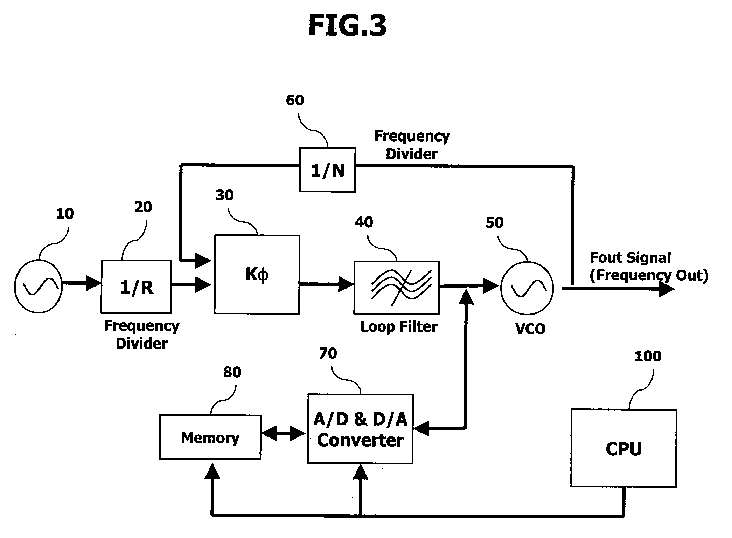

Figure 3 is a block diagram showing a structure of a PLL circuit in accordance with an example embodiment of the present invention. Other embodiments and configurations are also within the scope of the present invention.

A PLL circuit in accordance with an example embodiment of the present invention may include a memory 80, a processor 100 and an A/D & D/A converter 70. The memory 80 may store a VCO control voltage (by system channels). The processor 100 (also referred to as a Central Process Unit (CPU)) may load a VCO control voltage, which corresponds to a changed channel, from the memory 80 when a system channel is changed, and provide the VCO control voltage to the VCO 50.

The signal converter 70 may convert a VCO control voltage value to a digital signal to transmit the signal to the memory 80 or convert information of the memory 80 to an analog signal to transmit the signal to the VCO 50.

Other components of the PLL circuit such as a frequency generator 10, a first frequency divider 20, a phase detector 30, a loop filter 40, a VCO 50, and a second frequency divider 60 may operate in a similar manner as discussed above.

When a system changes a channel, if an output signal (Fout signal) of the PLL circuit is locked at a frequency of a new channel (e.g., channel a), the CPU 100 may store a control voltage (e.g., control voltage β) that has been provided to the VCO 50 when the output signal (Fout signal) is locked up, in a memory 80. When a system uses a channel a, the CPU 100 may load the control voltage β from the memory 80. Then, the loaded control voltage β may be used as an initial value of the control voltage of the VCO 50.

The control voltage β may be converted to a digital signal by the signal converter 70, and then stored in the memory 80. In addition, when the stored information in the memory 80 is loaded to the VCO 50, the digital signal may be converted into an analog signal by the signal converter 70.

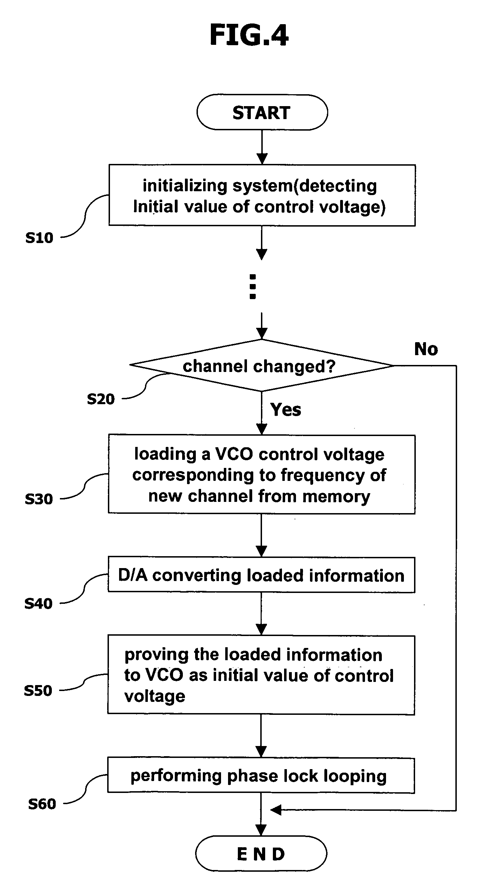

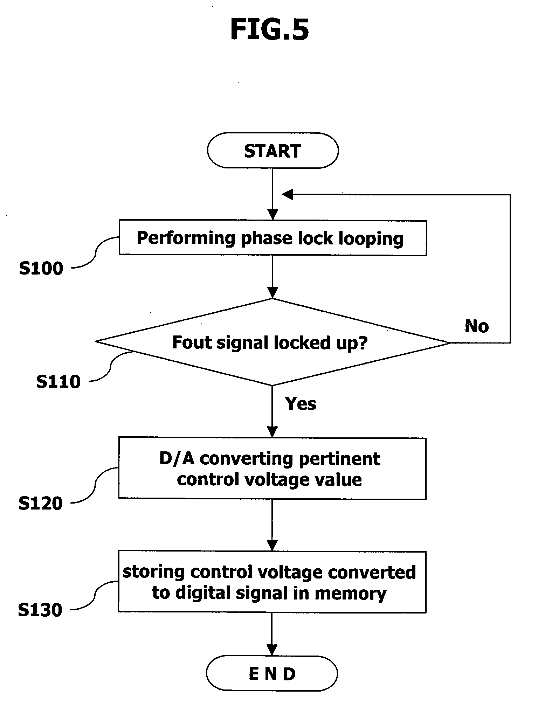

Figure 4 is a flow chart showing an operation method of a PLL circuit in accordance with an example embodiment of the present invention. Figure 5 is a flow chart showing processes of detecting an initial voltage according to an example embodiment. Other embodiments, configurations, operations, and orders of operations are also within the scope of the present invention.

Figure 4 shows that the method may include obtaining initial values of VCO control voltages of every channel and storing the initial values in the memory (S10). Information may be loaded of a frequency of a changed channel from a memory if a system changes a channel (S20, S30). The loaded information may be converted to an analog signal (S40). The converted information may be set as an initial value of the control voltage of the VCO (S50) and a Phase Lock looping may be performed (S60). Other operations and orders of operations are also within the scope of the present invention.

As shown in Figure 5, storing the VCO control voltage to a memory may include obtaining a VCO control voltage by performing a phase lock looping (S100, S110). The VCO control voltage value may be converted to a digital signal (S120). The converted VCO control voltage value may be stored to the memory (S130).

The PLL circuit may include a memory 80 to store initial values of control voltages to be provided to the VCO 50. Initial values of control voltages stored in the memory 80 may be obtained while initializing a system or may be stored in the memory 80 in producing a pertinent system. In at least one embodiment, detecting an initial voltage (S10) in order to store initial voltages of VCO control voltages may be performed in initializing the pertinent system.

Detecting an initial voltage (S10) will now be described. When a system is initialized, a PLL circuit may select one channel, and perform a phase lock looping for a frequency of the channel (S100 in Figure 5). Then, if an output signal (i.e., the Fout signal) of the PLL circuit is locked up at a frequency of the pertinent channel, the PLL circuit may detect a control voltage provided to the VCO 50 and convert the detected control voltage to a digital signal (S110, S120). Then, the control voltage that has been converted to the digital signal may be stored in the memory 80 (S130).

The processes (S100 ~ S130) may be repeatedly performed until VCO control voltages of every channel frequency used for a system are obtained.

Operations of the PLL circuit in accordance with an example embodiment of the present invention will now be described. If a channel of a system is changed (S20), the CPU 100 may load a VCO control voltage, which corresponds to the changed channel, from the memory 80 (S30). The signal converter 70 may convert the loaded VCO control voltage to an analog signal and then apply the converted VCO control voltage to the VCO 50 (S40, S50).

Instead of a control voltage transmitted from the loop filter 40, the VCO 50 may receive a control voltage loaded from the memory 80 as an initial value of the VCO control voltage. If the initial value of the control voltage is applied to the VCO 50, the PLL circuit may perform a full-scale phase lock looping (S60) in order to obtain a frequency of the changed channel. The phase lock looping of the PLL circuit may be performed in the same manner as discussed above.

The VCO may be sensitive to a temperature or an ambient environment. Therefore, the VCO control voltage for locking to a specific frequency may not always be the same. However, if a VCO control voltage that has previously locked to a frequency is used as an initial voltage of a VCO control voltage of the VCO 50, the PLL circuit can lock to a frequency more quickly.

If loading a control voltage from the memory 80 is completed, the CPU 100 may disable the signal converter 90 so as not to disturb a phase lock looping.

Whenever a system changes a channel, a control voltage of a pertinent channel frequency that has been stored in the memory may be used as an initial value of a control voltage provided to the VCO 50 so that a time consumed in a phase lock looping is remarkably reduced. Since embodiments of the present invention can be applied into various fields, it is expected to contribute to improve a processing speed of various communication equipments and their performance.

Embodiments of the present invention may be embodied in several forms without departing from the spirit or essential characteristics thereof. It should also be understood that the above-described embodiments are not limited by any of the details of the foregoing description, unless otherwise specified, but rather should be construed broadly within its spirit and scope as defined in the appended claims, and therefore all changes and modifications that fall within the metes and bounds of the claims, or equivalence of such metes and bounds are therefore intended to be embraced by the appended claims.

## Claims

1. A phase lock loop (PLL) circuit comprising:
a memory to store a control voltage; and
a processor to load a control voltage, which corresponds to a changed channel, from the memory when a system channel is changed, and to provide the control voltage to a Voltage Control Oscillator (VCO).

2. The PLL circuit of claim 1, wherein the control voltage of the memory is provided to the VCO as an initial value of the control voltage.

3. The PLL circuit of claim 1, wherein once the control voltage of the memory is provided to the VCO, the processor cuts off a path between the memory and the VCO.

4. The PLL circuit of claim 1, wherein the control voltage is stored when a system including a PLL is initialized.

5. The PLL circuit of claim 1, further comprising a signal converter to convert a control voltage to a digital signal and transmit the digital signal to the memory.

6. The PLL circuit of claim 1, further comprising a signal converter to convert control voltage information of the memory to an analog signal and transmit the analog signal to the VCO.

7. The PLL circuit of claim 6, wherein once the analog signal is transmitted to the VCO, the signal converter is disabled.

8. A method for synchronizing a phase of a frequency in a PLL circuit comprising:
storing a control voltage in a memory;
loading the control voltage, which corresponds to a changed channel, from the memory to a VCO; and
setting the control voltage as an initial control voltage.

9. The method of claim 8, further comprising performing a phase lock looping.

10. The method of claim 8, wherein the control voltage is loaded to the VCO when a system channel is changed.

11. The method of claim 8, wherein the control voltage is stored when a system including the PLL is initialized.

12. The method of claim 8, wherein storing the control voltage comprises:
obtaining the control voltage by performing a phase lock looping;
converting the control voltage to a digital signal; and
storing the converted control voltage in the memory.

13. The method of claim 12, wherein storing the control voltage is repeatedly performed until control voltages for every channel of a system are obtained.

14. The method of claim 8, further comprising converting the loaded control voltage information to an analog signal.

15. A phase lock loop (PLL) circuit comprising:
a voltage controlled oscillator (VCO) to output a signal based on a voltage of an input signal;
a memory device to store a control voltage; and
a processor to load the control voltage from the memory device to the VCO.

16. The PLL circuit of claim 15, wherein the processor loads the control voltage from the memory device to the VCO when a system channel is changed.

17. The PLL circuit of claim 16, wherein the control voltage corresponds to a changed channel.

18. The PLL circuit of claim 15, further comprising a signal converter to convert signals from analog to digital and from digital to analog.

19. The PLL circuit of claim 15, wherein the control voltage is used as an initial value of a control voltage of the VCO.

20. The PLL circuit of claim 15, further comprising a frequency generator, a phase detector, a loop filter and first and second frequency dividers.
